Europäisches Patentamt

European Patent Office

Office européen des brevets

(11) Publication number: **0 415 526 A2**

# EUROPEAN PATENT APPLICATION

(21) Application number: 90307231.2

(51) Int. Cl.⁵: **H01L 23/522**

(22) Date of filing: 02.07.90

The title of the invention has been amended (Guidelines for Examination in the EPO, A-III, 7.3).

(30) Priority: 30.06.89 JP 170115/89

(43) Date of publication of application:
06.03.91 Bulletin 91/10

(84) Designated Contracting States:
DE FR GB

(71) Applicant: MATSUSHITA ELECTRIC
INDUSTRIAL CO., LTD.
1006, Oaza Kadoma
Kadoma-shi, Osaka-fu, 571(JP)

(72) Inventor: Okuda, Yasushi
2-11-8, Nanpeidai
Takatsuki-shi, Osaka(JP)
Inventor: Esaki, Hideya
G-108, 1-24, Kami Shinden
Toyonaka-shi, Osaka(JP)

(74) Representative: Senior, Alan Murray et al
J.A. KEMP & CO 14 South Square Gray's Inn
London WC1R 5EU(GB)

(54) Semiconductor device having wiring layers.

(57) A semiconductor device comprising a substrate (2) and provided thereon an nth-layer wiring (21) and an n+mth-layer wiring (22, 23), where n and m are each a natural number, wherein;
a terrace (10) is provided beneath said nth-layer wiring (21) at the position corresponding to a joining part (40) between said nth-layer wiring (21) and said n+mth-layer wiring (22, 23).

Also disclosed is a process for manufacturing the semiconductor device.

FIG. 1A

EP 0 415 526 A2

## SEMICONDUCTOR DEVICE AND PROCESS FOR MAKING THE SAME

This invention relates to a semiconductor device having a multi-layer wiring structure, used in the field of semiconductor large-scale integrated circuits. It also relates to a process for making the same.

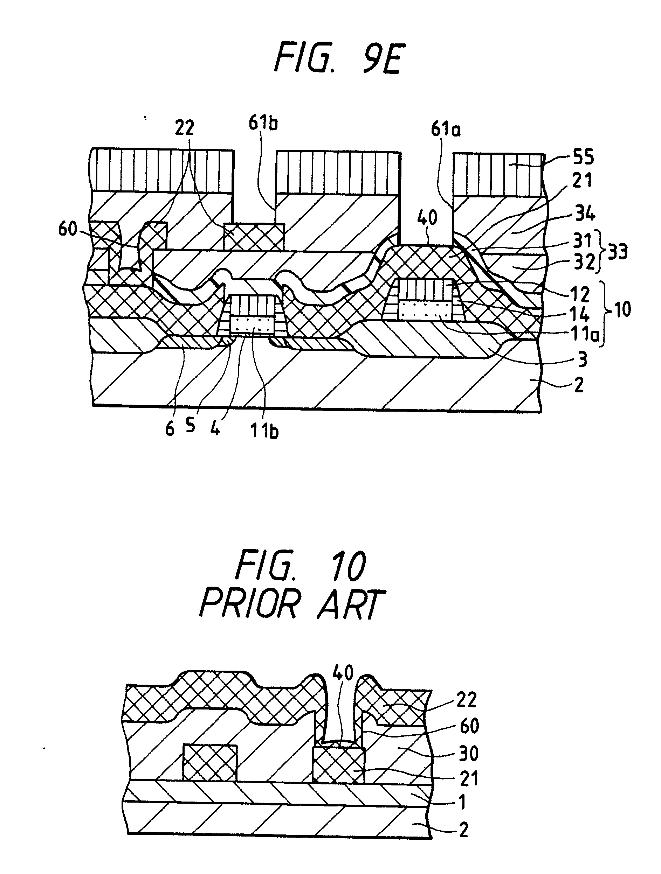

When multi-layer wiring is formed in a semiconductor large-scale integrated circuit, it has been hitherto prevailing to use a method in which nth-layer wiring (n is a natural number) is first formed, thereafter an interlaminar insulating film is formed on the nth-layer wiring over the whole surface of a semiconductor device, then the interlaminar insulating film is selectively removed using a mask to make an opening called a through-hole at the part at which the nth wiring and another n + 1th-layer wiring are intended to be connected, and then the n + 1th-layer wiring is buried in the through-hole to form a joined part. A multi-layer wiring structure in which first-layer wiring and second-layer wiring are connected by the formation of a through-hole will be described below with reference to Fig. 10.

As shown in Fig. 10, first-layer metal wiring 21 is firstly formed on a backing formed on a semiconductor substrate 2, and an interlaminar insulating film 30 is formed on the first-layer metal wiring over the whole surface of the semiconductor device, then the interlaminar insulating film 30 is selectively removed using a mask to make a through-hole 60, and then second-layer metal wiring 22 is buried in the through-hole to form a joined part 40.

However, the aspect ratio (ratio of the depth of a through-hole to the size of the opening of the through-hole) increases as a semiconductor device is made more minute and the size of the opening of a through-hole is made smaller, and hence it becomes difficult to bury the second-layer metal wiring 22 into the through-hole 60, so that the second-layer metal wiring 22 has an excessively small thickness in the vicinity of the joined part 40 formed at the bottom of the through-hole 60. On the other hand, if the interlaminar insulating film 30 is made smaller in thickness so that the aspect ratio of the through-hole 60 can be made smaller, it follows that the interlaminar insulating film 30 has poor insulating properties or that an increase in the capacitance of wiring is caused which is particularly questioned as a semiconductor integrated circuit is made more minute and more highly integrated. To make the metal wiring smaller in thickness not only causes a lowering of yield but also brings about problems that are important in view of the reliability of multi-layer wiring. Such problems are exemplified by disconnection caused by stress migration (grain boundary migration of wiring, caused by stress in a high-temperature environment) or electromigration (a phenomenon in which the momentum of a high-density electron stream under conditions of high-temperature and high current density causes wiring metal atoms to move).

The present invention was made under such circumstances. An aim of the present invention is to provide a semiconductor device, and a process for making the device, that can achieve a high yield and a high reliability without causing a lowering of insulating properties of an interlaminar insulating film or an increase in the capacitance of wiring.

Another aim of the present invention is to achieve the above object without bringing about an increase in manufacturing steps.

According to a first aspect of the present invention, there is provided a semiconductor device comprising a substrate and provided thereon an nth-layer wiring and an n + mth-layer wiring, where n and m are each a natural number, wherein; a terrace is provided beneath said nth-layer wiring at the position corresponding to a joining part between said nth-layer wiring and said n + mth-layer wiring.

In an embodiment of the present invention, the terrace has the same constitution as that of a gate electrode of a MOSFET (metal-oxide-semiconductor field-effect transistor) covered with an insulating film.

According to a second aspect of the present invention there is provided a process for manufacturing a semiconductor device, comprising the steps of:
first forming a terrace beneath a joining part between nth-layer wiring and n + mth-layer wiring;
thereafter forming said nth-layer wiring;
forming an interlaminar insulating film on said nth-layer wiring;
removing part of said interlaminar insulating film so that said nth-layer wiring is uncovered at said joining part; and
thereafter forming said n + mth-layer wiring on said joining part.

In the present invention, a terrace is provided beneath the nth-layer wiring at the position corresponding to a joining part between the nth-layer wiring and the n + mth-layer wiring. Hence, the thickness of the wiring at the joining part can be prevented from becoming smaller, without making small the thickness of an interlaminar insulating film, and also a high yield and a high reliability can be achieved in a minute multi-layer wiring structure.

In the semiconductor device according to some embodiments of the present invention, the terrace has the same constitution as that of a gate electrode of a MOSFET. Hence, a high yield and a high reliability of multi-layer wiring can be achieved without bringing about an increase in manufacturing steps in a semiconductor device having a MOSFET.

The present invention will be further described hereinafter with reference to the following description of exemplary embodiments and the accompanying drawings, in which:

Figs. 1A and 1B each cross-sectionally illustrate the structure of a semiconductor device according to Example 1 of the present invention.

Figs. 2A to 2F cross-sectionally illustrate a process in the manufacture of the semiconductor device according to Example 1 of the present invention.

Fig. 3 cross-sectionally illustrates the structure of a semiconductor device according to Example 2 of the present invention.

Figs. 4A to 4F cross-sectionally illustrate a process in the manufacture of the semiconductor device according to Example 2 of the present invention.

Figs. 5A to 5F cross-sectionally illustrate a process in the manufacture of a semiconductor device according to Example 3 of the present invention.

Fig. 6A is a diagram of characteristics, showing initial resistance of a chain of through-holes of 0.8 μm in diameter in Example 3 of the present invention.

Fig. 6B is a diagram of characteristics, showing electromigration resistance of a chain of through-holes of 0.8 μm in diameter in Example 3 of the present invention.

Figs. 7A to 7D cross-sectionally illustrate a process in the manufacture of a semiconductor device according to Example 4 of the present invention.

Fig. 8 cross-sectionally illustrates the structure of a semiconductor device according to Example 5 of the present invention.

Figs. 9A to 9E cross-sectionally illustrate a process in the manufacture of the semiconductor device according to Example 5 of the present invention.

Fig. 10 cross-sectionally illustrates the structure of a multi-layer wiring structure formed by the prior art.

In the present invention having the above constitution, a terrace (i.e., a raised level with sloping side walls) is provided beneath nth-layer wiring at the position corresponding to a joining part between the nth-layer wiring and n+mth-layer wiring. Hence, when the above nth-layer wiring has been formed, the height of the nth-layer wiring at the joining part can be made greater by the thickness of the terrace than the height of the nth-layer wiring at the part not constituting the joining part, so that an interlaminar insulating film can be formed on the nth-layer wiring in such a manner that only the part corresponding to the joining part, of the nth-layer wiring, can be made to uncover without use of a mask. Also when a through-hole is formed using a mask, the formation of the terrace makes it possible to decrease the aspect ratio of the through-hole. Thus, in the formation of the n+mth-layer wiring, the area of contact between the nth-layer wiring and the n+mth-layer wiring can be sufficiently secured at the joining part without bringing about the disadvantage that the n+mth-layer wiring may become smaller in thickness when minute through-holes are formed, because of a difficulty arising when wiring materials are buried. In addition, it is unnecessary to make small the thickness of the interlaminar insulating film between the nth-layer wiring and n+mth-layer wiring when they are formed, and hence sufficient insulating properties can be ensured without bringing about an increase in the capacitance of wiring.

Here, it is possible that the nth-layer wiring becomes smaller in thickness because of the terrace. Compared with an instance in which the deposition of a wiring material in a hollow as in the through-hole and the deposition of a wiring material on the terrace are carried out by sputtering, the incident solid angle of incident wiring material particles at the depressed part in the case of the hollow becomes smaller than $\pi$, and the incident solid angle becomes extremely smaller with the depth of depression. On the other hand, the incident solid angle of incident wiring material particles in the case when the terrace is provided becomes more than $\pi$, and hence there is less decrease in the deposited film thickness of the wiring material at the terrace. In addition, the slope of the terrace can be readily made gentle compared with the slope of the depression, and hence the wiring can be prevented with ease from becoming smaller in thickness.

In another embodiment of the present invention, the terrace having the same constitution as that of a gate electrode of a MOSFET covered with an insulating film may be formed at the same time the MOSFET is fabricated, so that no increase in steps is brought about in the manufacture of a semiconductor device having the MOSFET.


EXAMPLES


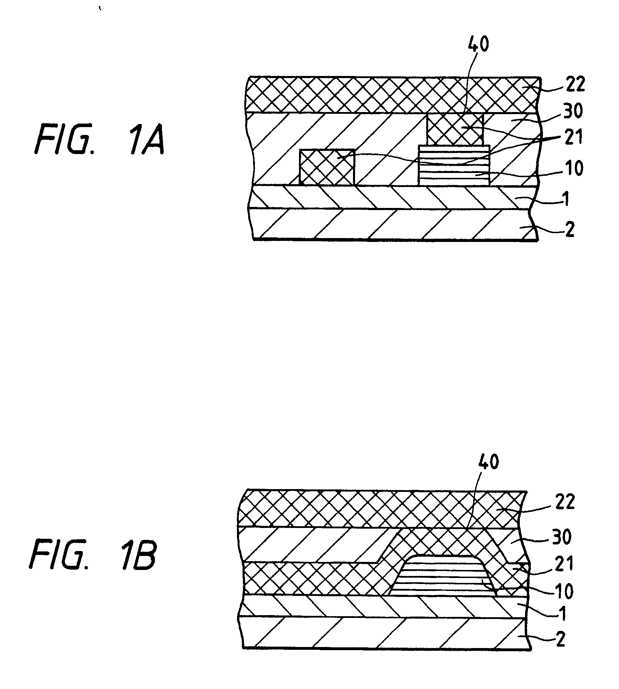

Embodiments of the present invention are divided into Examples 1 to 5 and will be described with reference to Figs. 1 to 9.

Example 1

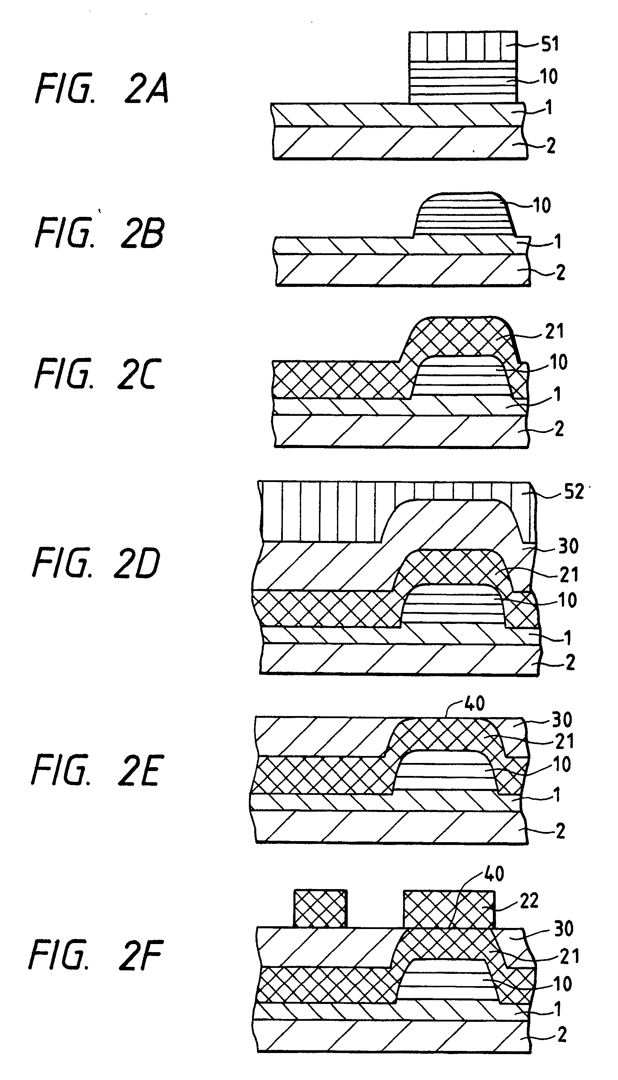

Example 1 of the present invention will be described with reference to Figs. 1A and 1B and Figs. 2A to 2F.

Fig. 1A illustrates a multi-layer wiring structure of an example in which first-layer metal wiring 21 and second-layer metal wiring 22 cross at right angles; and Fig. 1B, an example in which the first-layer metal wiring 21 and the second-layer metal wiring 22 are parallel. Both examples of Figs. 1A and 1B illustrate a two-layer wiring structure in which the first-layer metal wiring 21, an interlaminar insulating film 30 and the second-layer metal wiring 22 are provided on a backing 1 formed on a semiconductor substrate 2 and a terrace 10 is formed beneath a joining part 40 between the first-layer metal wiring 21 and second-layer metal wiring 22.

Next, a manufacturing process of the device of the present embodiment is shown in Figs. 2A to 2F. First, a silicon oxide film, for example, is formed by deposition on the backing 1 formed on a silicon substrate 2 serving as the semiconductor substrate, so as to cover the whole surface of the semiconductor device. Then, using a resist 51, the above silicon oxide film is selectively removed to form the terrace 10 (Fig. 2A). Next, after the resist 51 is removed, etching is carried out using, for example, argon (Ar) gas, where edges of the terrace 10 are etched at a higher rate, so that the edges of the terrace 10 are rounded as shown in Fig. 2B. Next, the first-layer metal wiring 21 comprised of, for example, aluminum (Al) is formed as shown in Fig. 2C. Subsequently, the interlaminar insulating film 30 comprised of, for example, a silicon oxide film is formed by deposition to have a larger film thickness than that of the terrace 10, and a leveling resist 52 is further coated so as to give a flat surface (Fig. 2D). Next, the interlaminar insulating film 30 and the leveling resist 52 are subjected to dry etching at the same rate so that they are removed until a joining part 40 of the first-layer metal wiring 21 is uncovered as shown in Fig. 2E. Finally, the second-layer metal wiring 22 comprised of, for example, aluminum (Al) is formed. A multi-layer wiring structure as shown in Fig. 2F is thus formed.

As in Figs. 1A and 1B and Fig. 2F, the terrace 10 is formed beneath the joining part 40. As a result, the position of the first-layer metal wiring 21 becomes higher only at the position of the joining part 40, and hence the area of contact between the first-layer metal wiring 21 and second-layer metal wiring 22 can be sufficiently secured without bringing about the disadvantage that the second-layer metal wiring 22 becomes smaller in thickness, and, in addition, the interlaminar insulating film 30 can assure sufficient insulation between the first-layer metal wiring 21 and second-layer metal wiring 22 at the region except the joining part 40. A good multi-layer wiring structure can be thus formed.

As described above, a high yield and a high reliability against stress migration and electromigration can be achieved even when a minute multi-layer wiring structure is formed.

The terrace 10 may also be formed of a conductive film of, for example, aluminum (Al). It thereby becomes possible to completely eliminate the disadvantage that the metal wiring layer becomes smaller in thickness at the joining part 40 and thus further improve the reliability. In addition, as shown in Fig. 1A, the width of the terrace 10 may be made larger than the width of the first-layer metal wiring 21. It thereby becomes possible to prevent troubles from occurring at the joining part 40 which are caused by the deviation of patterns when the terrace 10, first-layer metal wiring 21 and second-layer metal wiring 22 are each subjected to patterning.

Example 2

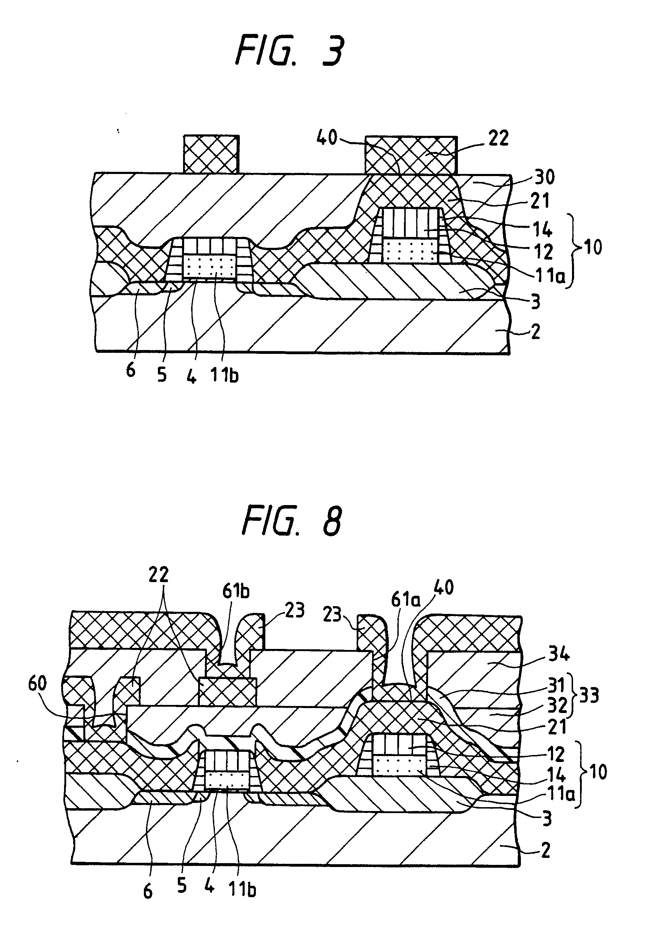

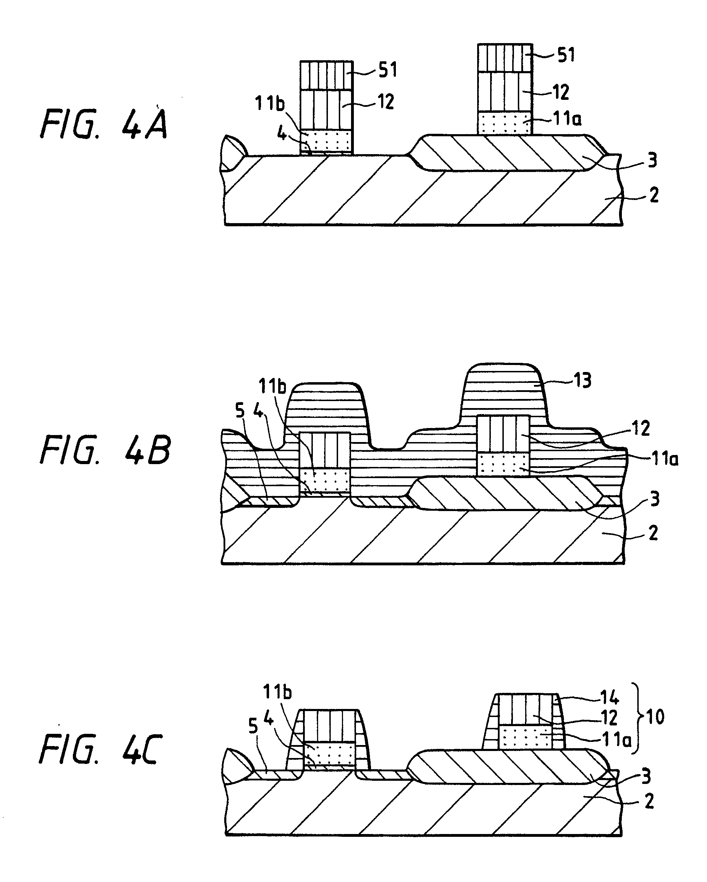

Example 2 of the present invention will be described with reference to Fig. 3 and Figs. 4A to 4F.

In the embodiment shown in Fig. 3, a device isolation region 3 formed on a p-type semiconductor substrate 2 serves as a backing. A terrace 10 comprised of a gate electrode 11a covered with a covering oxide film 12 and a sidewall oxide film 14 is formed at the same time when a gate electrode 11b of a normal MOSFET formed beneath a joining part 40 by a conventional process is formed.

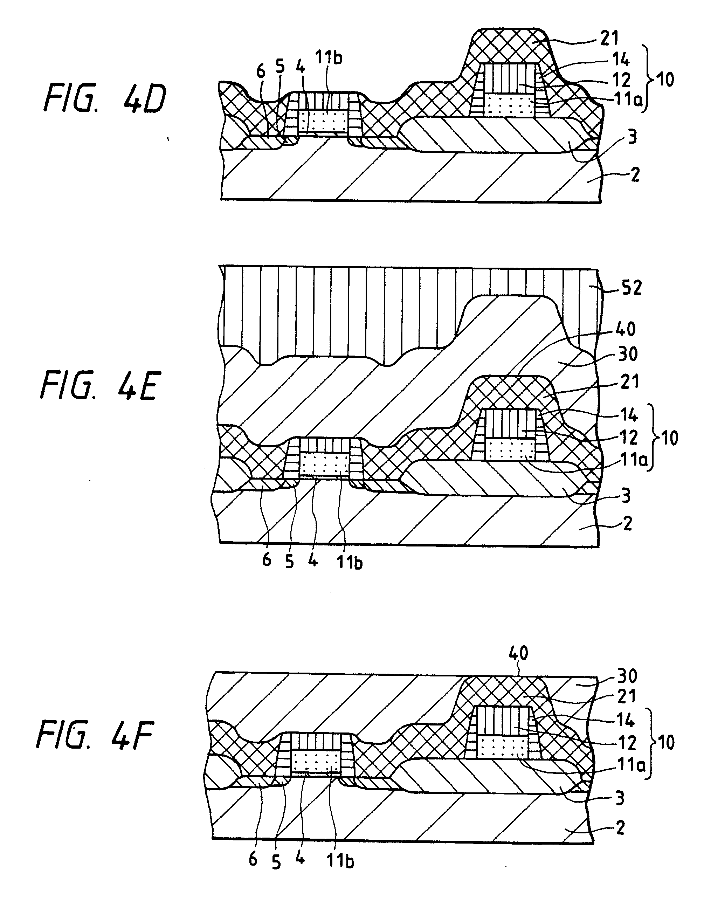

Next, a manufacturing process of the present embodiment is shown in Figs. 4A to 4F. First, the device isolation region 3 (with a film thickness of, for example, 600 nm) is formed on the p-type semiconductor substrate 2 by the LOCOS process (local oxidation process). Thereafter, a gate oxide film 4 (with a film thickness of, for example, 16 nm) is formed, and a gate electrode material comprising, for example, an $n^+$-type polycrystalline silicon film (with a film thickness of, for example, 250 nm) and a silicon oxide film (with a film thickness of, for example, 200 nm) are further deposited. Thereafter, the above gate electrode material and the above silicon oxide film are selectively removed using a resist 51, so that the gate electrodes 11a and 11b and the covering oxide films 12 are formed as shown in Fig. 4A. At this time, the gate electrode 11a on the device isolation region 3 and the gate electrode 11b on the gate oxide film 4 are simultaneously formed. The gate electrode 11a is used as the terrace 10 for the formation of a multi-layer wiring structure in the subsequent step and the gate electrode 11b is used as a gate electrode of the normal MOSFET. Next, the resist 51 is removed, and ions as exemplified by phosphate ions ($P^+$) are implanted so that an $n^-$-type semiconductor layer 5 is formed. Thereafter, a silicon oxide film 13 is formed by deposition as shown in Fig. 4B to have a given film thickness (for example, a film thickness of 250 nm), and then the silicon oxide film 13 is removed by anisotropic etching. As a result, a sidewall oxide film 14 with a width of about 250 nm is formed. Hence, the gate electrode 11a covered with an insulating film comprised of the covering oxide film 12 and the sidewall oxide film 14 constitutes the terrace 10 (with a total thickness of 450 nm in this example), and at the same time the slope of the side walls of the terrace 10 can be made gentle by virtue of the sidewall oxide film 14 (Fig. 4C). Subsequently, ions as exemplified by arsenate ions ($As^+$) are implanted so that an $n^+$-type semiconductor layer 6 serving as source and drain of the MOSFET is formed. Thereafter, an alloy of, for example, aluminum, silicon and copper (hereinafter referred to as Al-Si-Cu alloy) is deposited over the whole surface, and a first-layer metal wiring 21 (with a film thickness of, for example, 800 nm) is thus formed as shown in Fig. 4D. Next, an interlaminar insulating film 30 comprised of, for example, a silicon oxide film is formed by deposition over the whole surface of the semiconductor device to have a larger thickness (with a film thickness of, for example, 2,000 nm) so that it becomes higher than the joining part 40 formed at the surface of the first-layer metal wiring 21. A leveling resist 52 is further coated (with a coating thickness of, for example, 1,500 nm) so as to give a flat surface (Fig. 4E). Next, the interlaminar insulating film 30 and the leveling resist 52 are subjected to dry etching at the same rate so that they are removed until the joining part 40 at the surface of the first-layer metal wiring 21 positioned above the terrace 10 is uncovered as shown in Fig. 4F. Finally, a second-layer metal wiring 22 comprised of, for example, an Al-Si-Cu alloy is formed to give a multi-layer wiring structure as shown in Fig. 3. Thus the area of contact between the first-layer metal wiring 21 and second-layer metal wiring 22 can be sufficiently secured without bringing about the disadvantage that the second-layer metal wiring 22 becomes smaller in thickness, and, in addition, the interlaminar insulating film 30 can assure sufficient insulation between the first-layer metal wiring 21 and second-layer metal wiring 22 at the region except the joining part 40. A good multi-layer wiring structure can be thus formed.

As described above, a high yield and a high reliability against stress migration and electromigration can be achieved even when a minute multi-layer wiring structure is formed. In addition, the terrace 10 is formed at the same time when the MOSFET is formed, so that not only no increase in manufacturing steps is brought about for the formation of the terrace 10, but also the number of masks used can be reduced compared with conventional methods since the step of forming through-holes becomes unnecessary.

In the present embodiment, as will be clear from the above description, not only the multi-layer wiring structure and the MOSFET are simultaneously formed but also the $n^+$-type semiconductor layer 6 serving as source and drain of the MOSFET are joined in self-alignment without use of a mask.

In the present example, a silicon oxide film is used as the gate oxide film 4 of the MOSFET. Needless to say, however, the multi-layer wiring structure employing the terrace according to the present invention can also be applied in a MOSFET structure comprising an insulating film other than the silicon oxide film, as exemplified by a laminated film of a silicon oxide film and a silicon nitride film.

## Example 3

Example 3 of the present invention will be described with reference to Figs. 5A to 5F.

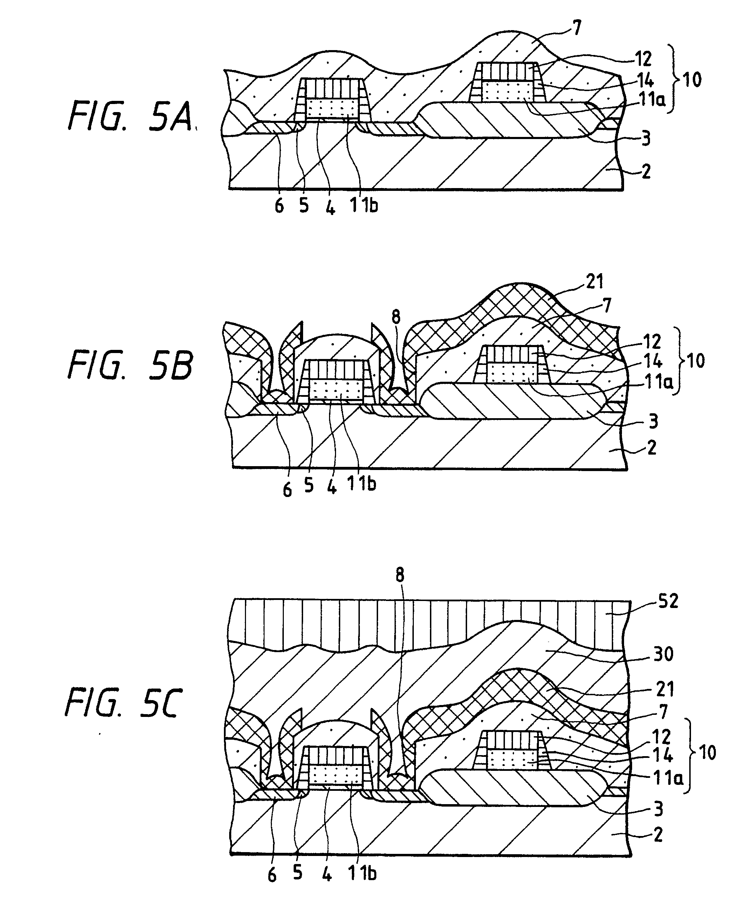

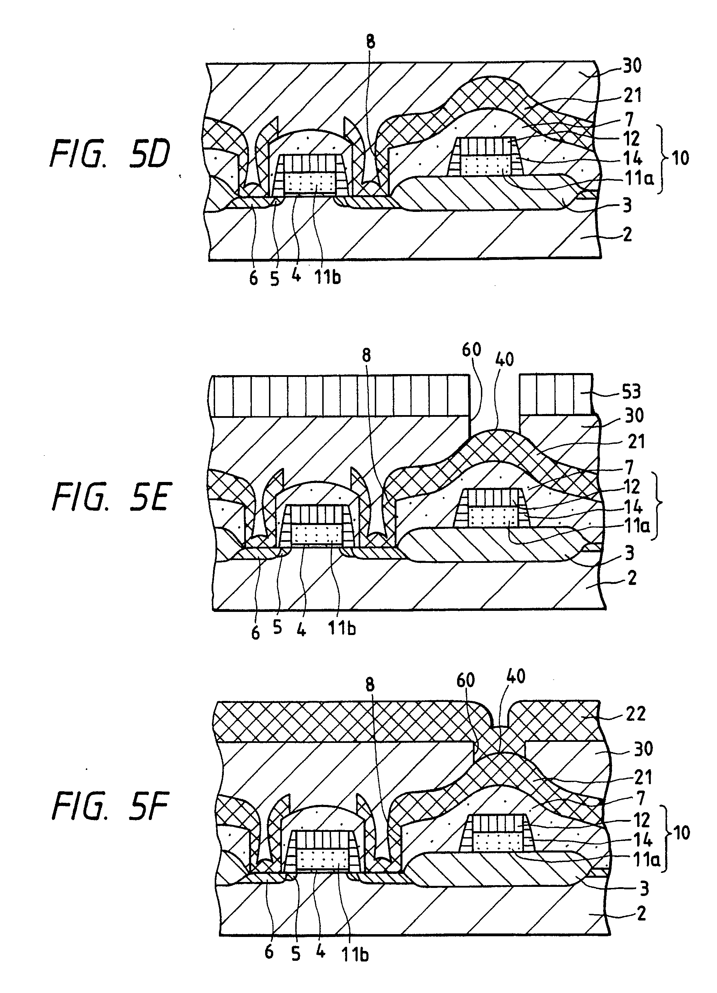

The manufacturing steps of from the formation of a MOSFET up to the formation of a terrace 10 are the same as the steps shown in Figs. 4A to 4C. Accordingly, descriptions on these steps are omitted. After the step shown in Fig. 4C, ions as exemplified by arsenate ions ($As^+$) are implanted so that an $n^+$-type semiconductor layer 6 serving as source and drain of the MOSFET is formed. Thereafter, a BPSG (borophosphosilicate glass) film 7 is formed by deposition over the whole surface of the semiconductor device to give a given film thickness (a film thickness of, for example, 350 nm), and then a suitable heat treatment (for example, at 900° C for 30 minutes) is applied to effect reflowing of the BPSG film 7 so that the form of the terrace on the surface can be made a little gentle. This is a treatment by which the top of the normal gate electrode 11b is made flat and also the form of the terrace 10 is made optimum (Fig. 5A). Subsequently, the BPSG film 7 is selectively etched using a mask to form a contact hole 8 on the source and drain and the gate electrode 11b (a contact hole with respect to a gate electrode 11a is not shown). Thereafter an Al-Si-Cu alloy, for example, is deposited over the whole surface, and a first-layer metal wiring 21 (with a film thickness of, for example, 800 nm) is formed as shown in Fig. 5B. Then, an interlaminar insulating film 30 comprised of, for example, a silicon oxide film is formed by deposition over the whole surface of the semiconductor device to have a larger thickness (with a film thickness of, for example, 2,000 nm) so that it becomes higher than the joining part 40 formed at the surface of the first-layer metal wiring 21. A leveling resist 52 is further coated (with a coating thickness of, for example, 1,500 nm) so as to give a flat surface (Fig. 5C). Next, the interlaminar insulating film 30 and the leveling resist 52 are subjected to dry etching at the same rate so that the interlaminar insulating film 30 is made flat to have a given thickness (for example, a film thickness of 600 nm on the first-layer metal wiring 21 formed on the flattened surface). At this time, the interlaminar insulating film 30 is made to remain on the whole surface of the semiconductor device, in other words, to remain also on the joining part 40 at the surface of the first-layer metal wiring 21 positioned above the terrace 10 (Fig. 5D). Next, the interlaminar insulating film 30 is selectively removed using a resist 53 to form a through-hole 60 so that the joining part 40 of the first-layer metal wiring 21 is uncovered (Fig. 5E). Finally, after the resist 53 is removed, a second-layer metal wiring 22 (with a film thickness of, for example, 1,000 nm) comprised of, for example, an Al-Si-Cu alloy is formed to give a multi-layer wiring structure as shown in Fig. 5F. As shown in Fig. 5F, the terrace 10 for making higher the position of the joining part 40 of the first-layer metal wiring 21 is used in combination with the through-hole 60 formed by selectively removing the interlaminar insulating film 30 by the use of a mask. Hence, the height of the terrace 10 can be reduced and also the aspect ratio of the through-hole can be made smaller, so that the first-layer metal wiring 21 and the second-layer metal wiring 22 may not become smaller in film thickness and the insulation between the first-layer metal wiring 21 and second-layer metal wiring 22 can be sufficiently ensured.

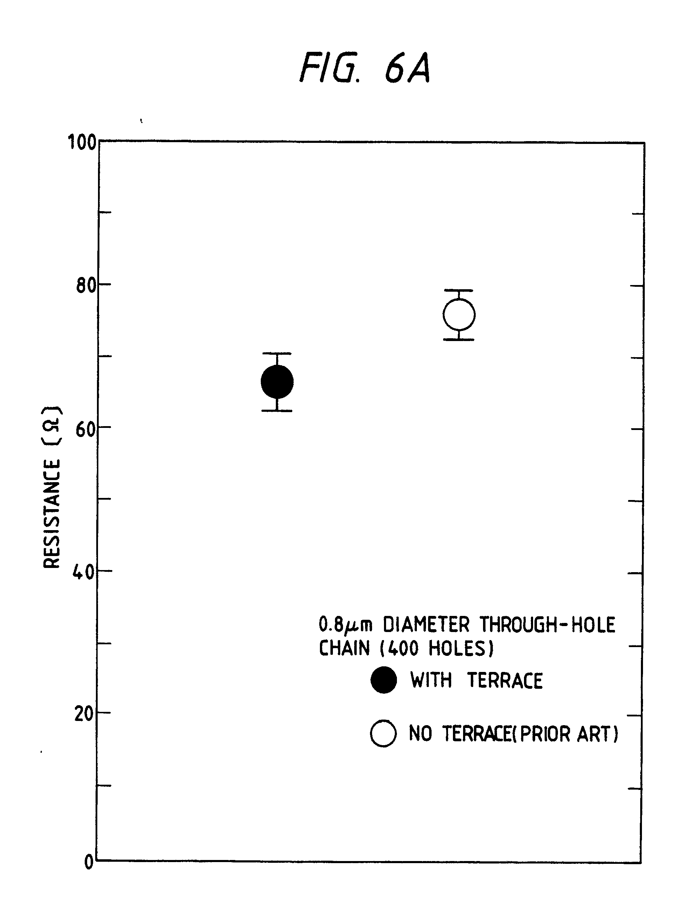

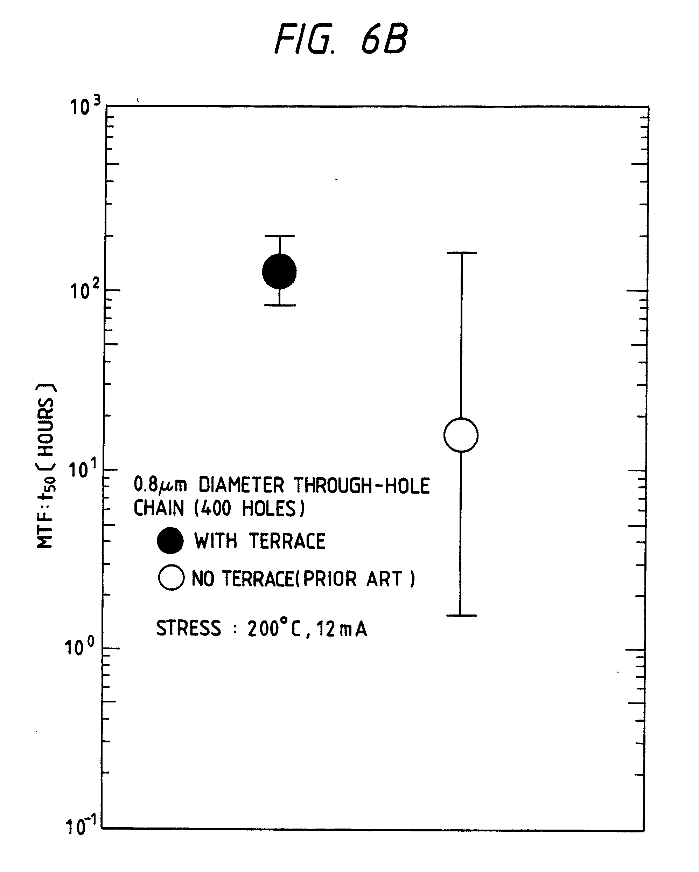

Here, evaluation was made on the joining part 40 between the first-layer metal wiring 21 and second-layer metal wiring 22 in the semiconductor device obtained by the manufacturing process of this embodiment. Results obtained will be described with reference to Figs. 6A and 6B.

The evaluation was made on a chain of through-holes (400 holes) of 0.8 $\mu$m in diameter, prepared exactly as described in this example, and electric characteristics were compared on whether or not the terrace 10 comprised of the gate electrode 11a of the MOSFET, insulated by the covering oxide film 12 and sidewall oxide film 14, is formed beneath the through-hole 60.

Fig. 6A is a diagram showing initial resistance of the chain of through-holes. The formation of the terrace has resulted in a decrease by 12.7 % in the resistance of the chain, but with substantially the same standard deviation of the resistance. The yield of the chain in a wafer of 6 inch in diameter was 97.8 % (44/45) when the terrace is provided, and 84.4 % (38/45) when no terrace is provided. Thus, it was confirmed that the second-layer Al-Si-Cu wiring can be buried in the through-hole in a greatly improved state when the terrace 10 is provided beneath the through-hole 10, and superior initial characteristics are exhibited in respect of the resistance and the yield.

Next, test results on the electromigration occurring in the chain of through-holes are shown in Fig. 6B. Stress was applied under conditions of an environmental temperature of 200 °C and an applied current of 12 mA. Mean time to failure (MTF: $t_{50}$) in a log-normal scale, and standard deviation ($\sigma$) of the time to failure were as follows: $t_{50}$ = 129 hours, $\sigma$ = 0.44 when the terrace is provided, and $t_{50}$ = 15.9 hours, $\sigma$ = 2.33 when no terrace is provided. Thus, when the terrace 10 is provided, it is possible to achieve a high reliability such that the mean time to failure was elongated as much as about 8 times and also the scattering in the time to failure was greatly reduced.

It was also confirmed that according to the manufacturing process of the present embodiment no troubles due to the disconnection or short between the first layer wiring and second layer wiring occurred on the gate electrode 11b of the normal MOSFET when the wiring had a width of up to 1.0 $\mu$m.

As will be clear from the above description, a high yield and a high reliability against stress migration and electromigration can be achieved even when a minute multi-layer wiring structure is formed. In addition, the terrace 10 is formed at the same time when the MOSFET is formed, so that no increase in manufacturing steps is brought about for the formation of the terrace 10.

Example 4

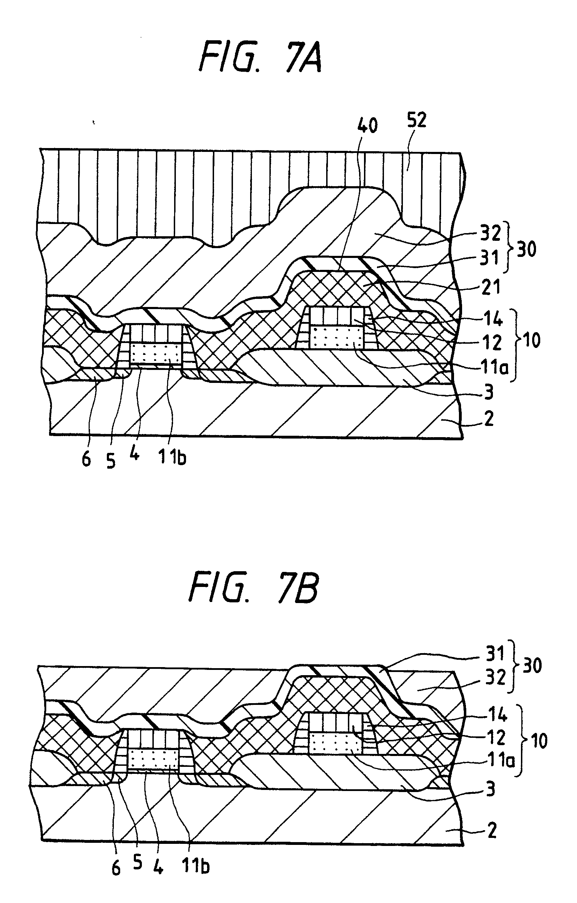

Example 4 of the present invention will be described with reference to Figs. 7A to 7D.

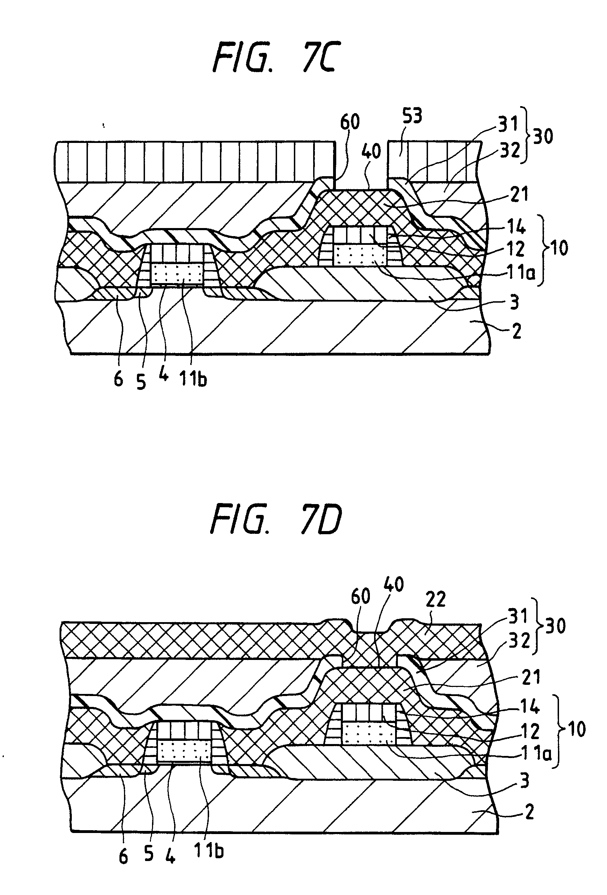

The manufacturing steps up to the formation of a first-layer metal wiring 21 are the same as the steps shown in Figs. 4A to 4D. Accordingly, descriptions on these steps are omitted. After the step shown in Fig. 4D, a silicon nitride film 31, for example, is formed by deposition to have a given film thickness (for example, a film thickness of 200 nm). Then a silicon oxide film 32, for example, is formed by deposition over the whole surface of the semiconductor device to have a larger thickness (with a film thickness of, for example, 2,000 nm) so that it becomes higher than the joining part 40 formed at the surface of the first-layer metal wiring 21. An interlaminar insulating film 30 comprised of the silicon nitride film 31 and the silicon oxide film 32 is thus formed. A leveling resist 52 is further coated (with a coating thickness of, for example, 1,500 nm) so as to give a flat surface (Fig. 7A). Next, the silicon oxide film 32 and the leveling resist 52 are subjected to dry etching at the same rate so that the surface of the silicon oxide film 32 is made flat, and the silicon oxide film 32 is further etched to the extent of a given thickness while the etching rate for the silicon oxide film 32 is made greater than that for the silicon nitride film 31 so that the silicon nitride film 31 is protrudingly uncovered as shown in Fig. 7C, above the joining part 40 at the surface of the first-layer metal wiring 21 positioned above the terrace 10. Here, since the etching rate for the silicon oxide film 32 is made sufficiently greater than that for the silicon nitride film 31, it may not occur that the silicon nitride film 31 is removed and the surface of the first-layer metal wiring 21 is uncovered. Thus the depth of a through-hole 60 formed in the subsequent step can be controlled in a good accuracy. Next, the silicon nitride film 31 is selectively removed using a resist 53 as a mask, whereby the through-hole 60 can be formed in a smaller depth (a film thickness of 200 nm in the present embodiment) and the joining part 40 of the first-layer metal wiring 21 is uncovered. At this stage, the resist 53 may not be used and instead the silicon oxide film 32 may be made to serve as a mask so that only the silicon nitride film 31 is removed and thus the joining part 40 is uncovered. Finally, after the resist 53 is removed, a second-layer metal wiring 22 (with a film thickness of, for example, 1,000 nm) comprised of, for example, an Al-Si-Cu alloy is formed to give a multi-layer wiring structure as shown in Fig. 7D. As shown in Fig. 7D, the terrace 10 for making higher the position of the joining part 40 of the first-layer metal wiring 21 is used in combination with the through-hole 60 formed by selectively removing the lower-layer insulating film 31 of the interlaminar insulating film 30 by the use of a mask. Hence, the height of the terrace 10 can be reduced and also the aspect ratio of the through-hole can be made smaller, so that the first-layer metal wiring 21 and the second-layer metal wiring 22 may not become smaller in film thickness and the insulation between the first-layer metal wiring 21 and second-layer metal wiring 22 can be sufficiently ensured.

As will be clear from the above description, a high yield and a high reliability against stress migration and electromigration can be achieved even when a minute multi-layer wiring structure is formed. In addition, the terrace 10 is formed at the same time when the MOSFET is formed, so that no increase in manufacturing steps is brought about for the formation of the terrace 10. The interlaminar insulating film 30 is formed in a laminated structure comprised of the silicon nitride film 31 and silicon oxide film 32, and the silicon nitride film 31 is selectively removed using a mask. Thus, the size of the opening at the joining part 40 can be controlled in an improved accuracy. The aspect ratio of the through-hole 60 can also be controlled depending on the film thickness of the silicon nitride film 31. Thus the aspect ratio can be made smaller with a decrease in film thickness of the silicon nitride film 31.

## Example 5

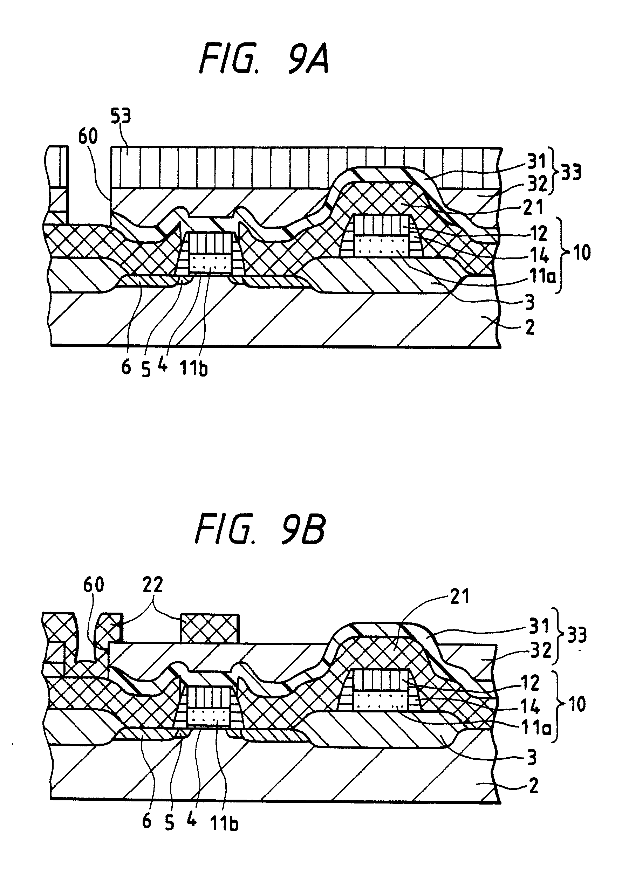

Example 5 of the present invention will be described with reference to Fig. 8 and Figs. 9A to 9E.

Fig. 8 shows a three-layer wiring structure comprised of a first-layer metal wiring 21, a second-layer metal wiring 22 and a third-layer metal wiring 23. In the embodiment shown in Fig. 8, a terrace 10 with the same constitution as a gate electrode of a MOSFET is formed beneath a joining part 40 between the first-layer metal wiring 21 and the third-layer metal wiring 23, and the three-layer metal wirings 21, 22 and 23 are connected each other through through-holes 60, 61a and 61b, respectively.

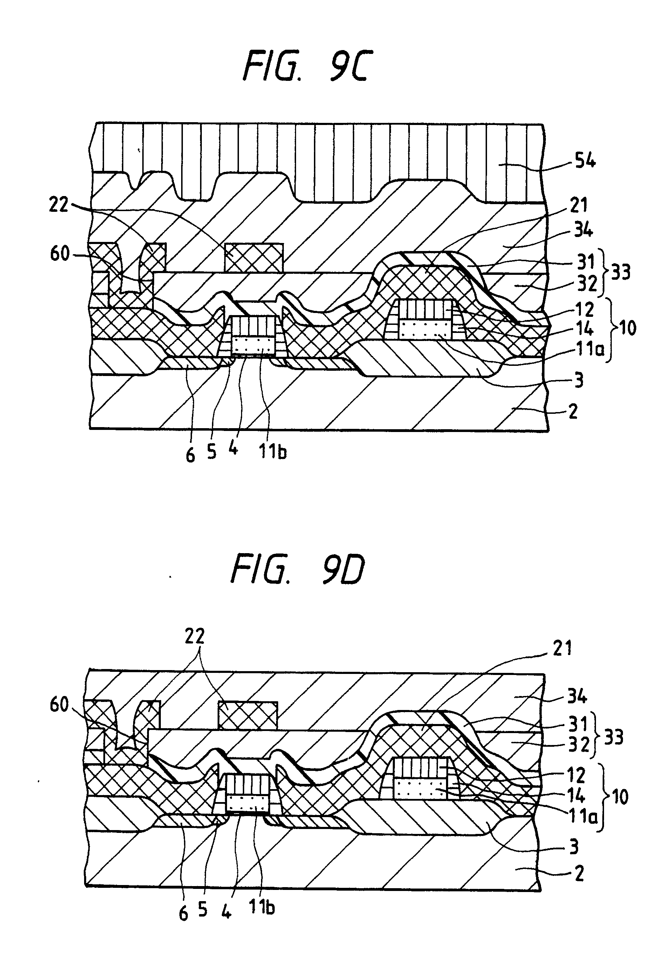

Next, a manufacturing process of the present embodiment is shown in Figs. 9A to 9E. The manufacturing steps up to the formation of a first interlaminar insulating film 33 comprised of a silicon nitride film 31 and a silicon oxide film 32 are the same as the steps up to the step shown in Fig. 7B. Accordingly, descriptions on these steps are omitted. After the step shown in Fig. 7B, the silicon oxide film 32 and the silicon nitride film 31 are selectively removed using a resist 53 as a mask, thereby forming the through-hole 60 as shown in Fig. 9A. Thereafter, the resist 53 is removed, and then a second-layer metal wiring 22 (with a film thickness of, for example, 600 nm) comprised of, for example, an Al-Si-Cu alloy is formed as shown in Fig. 9B. Next, a second interlaminar insulating film 34 comprised of, for example, a silicon oxide film is formed by deposition over the whole surface of the semiconductor device to have a large thickness (with a film thickness of, for example, 2,000 nm). A leveling resist 54 is further coated (with a coating thickness of, for example, 1,500 nm) so as to give a flat surface (Fig. 9C). Subsequently, the second interlaminar insulating film 34 and the leveling resist 54 are subjected to dry etching at the same rate so that the surface of the second interlaminar insulating film 34 is made flat as shown in Fig. 9D. Next, using a resist 55 as a mask, the second interlaminar insulating film 34 and the silicon nitride film 31 are selectively etched so that the through-hole 61a on the first-layer metal wiring 21 and the through-hole 61b on the second-layer metal wiring 22 can be simultaneously formed (Fig. 9E). Finally, after the resist 53 is removed, a third-layer metal wiring 23 (with a film thickness of, for example, 1,000 nm) comprised of, for example, an Al-Si-Cu alloy is formed to give a multi-layer wiring structure as shown in Fig. 8. As shown in Fig. 8, the terrace 10 is so provided that the first-layer metal wiring 21 is in substantially the same level as the second-layer metal wiring 22 at the joining part 40. Thus, it becomes possible for the first-layer metal wiring 21 and the second-layer metal wiring 22 to be simultaneously connected each other with the third-layer metal wiring 23. At this time, the through-hole 61a and the through-hole 61b can be made to have substantially the same smaller depth, and hence minute working can be carried out at a large tolerance, bringing about a remarkable increase in the degree of freedom in relation to the connection or joining between the three-layer wiring.

As will be clear from the above description, a high yield and a high reliability against stress migration and electromigration can be achieved even when a minute multi-layer wiring structure is formed. In addition, the degree of freedom can be increased in respect of the layout of the three-layer wiring, and hence the present invention has a very great effect on achieving larger-scale higher integration of complicated and various circuits as exemplified by microprocessors.

In the above, Examples 1 to 4 are concerned with multi-layer wiring structures comprised of first-layer wiring and second-layer wiring, and Example 5 shows a structure comprised of first-layer wiring, second-layer wiring and third-layer wiring. In general, however, the same results can also be obtained on a structure comprised of nth-layer wiring and $n + m$th-layer wiring (where n and m are each a natural number). In Examples 2, 3, 4 and 5, an Al-Si-Cu alloy is used as the material in metal wiring. Needless to say, however, it is also possible to use metal wiring of other alloys of an aluminum (Al) type, or high-melting metals of a titanium (Ti) type, a molybdenum (Mo) type and a tungsten (W) type, alloys of these, and laminated structures comprising any of these metals. Stated additionally, in Examples 2, 3, 4 and 5, the device isolation region is formed by the LOCOS process, but the device isolation region may also be formed by the buried oxide process (BOX process). A silicon substrate is used as the semiconductor substrate, but it is also possible to use a Ge substrate, an oxide semiconductor substrate, and other semiconductor substrates.

## Claims

1. A semiconductor device comprising a substrate and provided thereon an nth-layer wiring and an $n + m$th-layer wiring, where n and m are each a natural number, wherein;
a terrace is provided beneath said nth-layer wiring at the position corresponding to a joining part between said nth-layer wiring and said $n^+m$th-layer wiring.

2. A semiconductor device according to Claim 1, wherein said $n^+m$th-layer wiring is $n + 1$th-layer wiring.

3. A semiconductor device according to Claim 1, wherein said $n + m$th-layer wiring is $n + 2$th-layer wiring.

4. A semiconductor device according to claim 1,2 or 3, wherein said terrace has the same constitution as that of a gate electrode of a MOSFET.

5. A semiconductor device according to claim 1, 2 or 3, wherein said terrace comprises a conductive film.

6. A process for manufacturing a semiconductor device, comprising the steps of:
first forming a terrace beneath a joining part between nth-layer wiring and $n + m$th-layer wiring;
thereafter forming said nth-layer wiring;
forming an interlaminar insulating film on said nth-layer wiring;
removing part of said interlaminar insulating film so that said nth-layer wiring is uncovered at said joining part;
and
thereafter forming said $n + m$th-layer wiring on said joining part.

7. A process for manufacturing a semiconductor device according to claim 6, wherein said first interlaminar insulating film has a laminated structure comprised of at least two layers, and said step of removing part of said interlaminar insulating film comprises the steps of removing part of at least an uppermost layer of said first interlaminar insulating film so that a lower-layer insulating film that constitutes said interlaminar insulating film is protrudingly uncovered at the joining part between said nth-layer wiring and $n + m$th-layer wiring; and
selectively removing said lower-layer insulating film so that said nth-layer wiring is uncovered at said joining part.

8. A process for manufacturing a semiconductor device comprising the steps of:
first forming a terrace beneath a joining part between nth-layer wiring and $n + 2$th-layer wiring;
thereafter forming said nth-layer wiring;
forming a first interlaminar insulating film on said nth-layer wiring;
further forming $n + 1$th-layer wiring;

forming a second interlaminar insulating film on said n + 1th-layer wiring;

removing part of said first interlaminar insulating film and second interlaminar insulating film so that said nth-layer wiring is uncovered at said joining part; and

thereafter forming said n + 2th-layer wiring on said joining part and the uncovered part of said n + 1th-layer wiring.

9. A process for manufacturing a semiconductor device according to claim 8, wherein

at least one of said first and second interlaminar insulating films has a laminated structure comprised of at least two layers; and

said step of removing part of said first and second interlaminar insulating films comprising the steps of removing part of at least an uppermost layer of said first and second interlaminar insulating films so that a lower-layer insulating film that constitutes said first and second interlaminar insulating film is protrudingly uncovered at the joining part; and

selectively removing said lower-layer insulating film so that said nth-layer wiring is uncovered at said joining part.

10. A process for manufacturing a semiconductor device according to claim 6, 7, 8 or 9, wherein said step of forming a terrace comprises forming a terrace having the same constitution as that of a gate electrode of a MOSFET, on a device isolation region at the same time as the gate electrode is formed.

11. A process for manufacturing a semiconductor device according to claim 6, 7, 8 or 9, wherein said terrace comprises a conductive film.

12. A process for manufacturing a semiconductor device according to any one of claims 6 to 11, wherein said interlaminar insulating film on the nth-layer wiring is selectively removed using a mask so that said nth-layer wiring is uncovered at the joining part.

FIG. 1A

FIG. 1B

FIG. 2A

FIG. 2B

FIG. 2C

FIG. 2D

FIG. 2E

FIG. 2F

## FIG. 3

## FIG. 8

FIG. 4A

FIG. 4B

FIG. 4C

FIG. 4D

FIG. 4E

FIG. 4F

FIG. 5A.

FIG. 5B

FIG. 5C

FIG. 5D

FIG. 5E

FIG. 5F

# FIG. 6A

## FIG. 6B

STRESS : 200°C, 12 mA

0.8μm DIAMETER THROUGH-HOLE CHAIN (400 HOLES)
● WITH TERRACE
○ NO TERRACE(PRIOR ART )

FIG. 7A

FIG. 7B

## FIG. 7C

## FIG. 7D

# FIG. 9A

53
60
31 } 33
32
21
12
14 } 10
11a
3
2

6 5 4 11b

# FIG. 9B

60 22
21
31 } 33
32
12
14 } 10
11a
3
2

6 5 4 11b

## FIG. 9C

## FIG. 9D

## FIG. 9E

## FIG. 10
## PRIOR ART